# EUROPEAN PATENT SPECIFICATION

(11) **EP 0 423 054 B1**
(45) Date of publication and mention of the grant of the patent: **28.12.1994**
(21) Application number: 90610066.4
(22) Date of filing: 11.10.1990
(51) Int. Cl.: B23K 26/00, G02B 26/10, H04N 1/12

(54) **Method of producing printing plates by means of a laser beam**
Verfahren zur Herstellung von Druckplatten mit Hilfe eines Laserstrahls
Méthode de production de plaques d'impression par laser

(30) Priority: 13.10.1989 DK 5103/89
(43) Date of publication of application: 17.04.1991
(73) Proprietor: Krause-Biagosch GmbH, D-33649 Bielefeld (DE)
(72) Inventor: Nortoft, Soren, DK-8340 Malling (DK)
(74) Representative: Siiger, Joergen

(56) References cited:
- PATENT ABSTRACTS OF JAPAN vol. 6, no. 255 (P-162)(1133)14 December 1982 & JP-A-57 150 815 ( TOKYO SHIBAURA DENKI K.K. ) 17 September 1982
- PATENT ABSTRACTS OF JAPAN vol. 10, no. 348 (P-519)(2404)22 November 1986 & JP-A-61 148 419 ( HITACHI ) 7 July 1986
- PATENT ABSTRACTS OF JAPAN vol. 12, no. 492 (P-804)(3339)22 December 1988 & JP-A-63 204 224 ( FUJI XEROX ) 23 August 1988
- CONTROL ENGINEERING vol. 22, no. 3, May 1975, pages36 - 38; W.O. HENSCHE: 'methods for damping stepping motors'

## Description

The invention relates to a scanning device for producing printing plates comprising a laser for generating a laser beam, a polygonal mirror having the laser beam directed thereon, means for supporting the polygonal mirror for rotational movement on a rotational shaft a magnetic coupling for trasmitting a rotational movement to the polygonal mirror via the shaft such that the rotating polygonal mirror causes a scanning of the laser beam.

The known scanning devices of this type are not sufficiently accurate. JP-A-57150815 discloses e.g. a scanning device having a magnetic coupling in connection with a rotating polygonal mirror. Stickings or shocks will, however, greatly affect the rotary speed, and oscillations in the rotary speed might occur.

JP-A-61148419 discloses a scanning device comprising a rotating polygonal mirror. The rotional movement is transferred to the polygonal mirror by means of mechanical means in which case friction and sticking affect the rotational accuracy.

The object of the invention is to provide a scanning device of producing printing plates by means of a scanning laser beam directly from text and picture information in a computer, the scanning being performed at a high speed with a higher accuracy than previously known.

According to the invention the scanning device is characterised by means for dampening possible oscillations of the rotating polygonal mirror and rotational shaft by hysteresis, faraday dampening whereby as rotational movement is transferred to the polygonal mirror by means of the magnetic coupling, possible oscillations are dampened by hysteresis, faraday dampening. It has surprisingly turned out that a rotational accuracy is obtained which is considerably better than the accuracy to be expected by combining the known devices.

The invention is described in greater detail below with reference to the accompanying drawings, in which
Figure 1 illustrates the computer-to-plate principle according to the invention for exposing a printing plate by means of a laser beam,
Figure 2 illustrates the configuration of the laser exposing system,
Figure 3 a main control system of the laser exposing system,
Figure 4 a clock-correction system of the laser exposing system,
Figure 5 a front end system of the laser exposing system,
Figure 6 a polygon control system of the laser exposing system,
Figure 7 a control system for the exposure plane and included in the laser exposing system,
Figure 8 a beam expander control system of the laser exposing system,

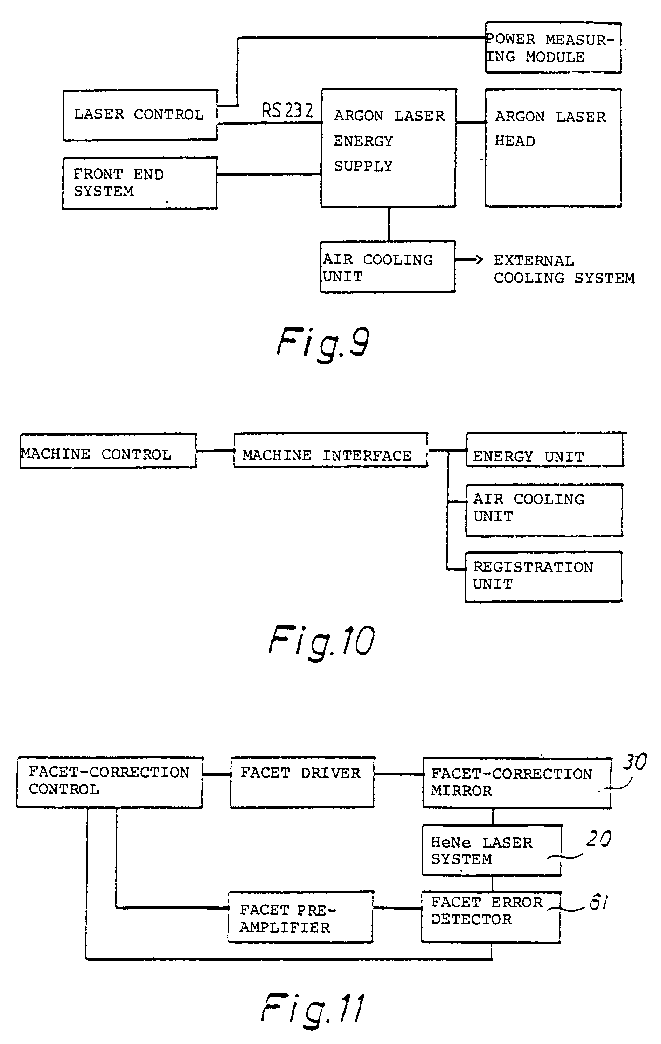

Figure 9 an argon laser system of the laser exposing system,
Figure 10 a machine control system of the laser exposing system,
Figure 11 a facet-correction system of the laser exposing system,
Figure 12 the optical system configuration,
Figure 13 an HeNe-laser system for correcting purposes,
Figure 14 the entire laser exposure unit,

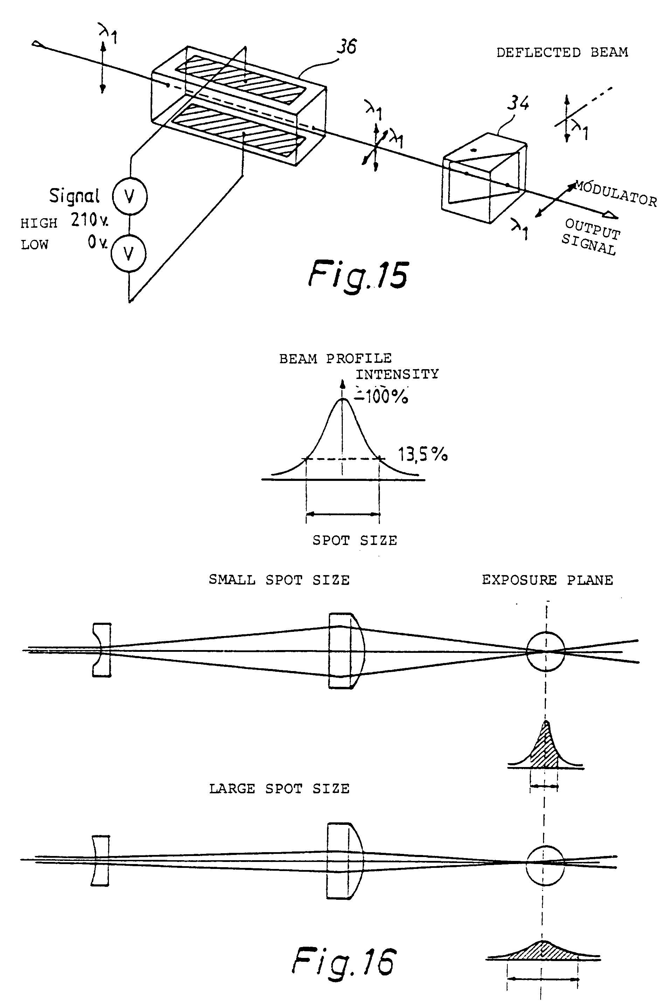

Figure 15 the mode of action of a modulator of the laser exposure unit,
Figure 16 the mode of action of a beam expander of the laser exposure unit,
Figures 17 and 18 a magnetic coupling in connection with the rotating polygonal mirror of the laser exposure unit, and

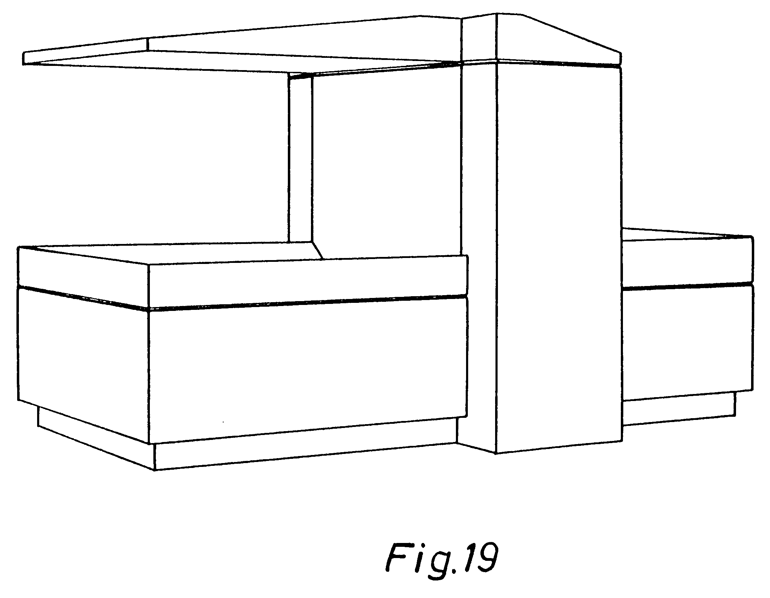

Figure 19 a perspective view of the laser exposure unit.

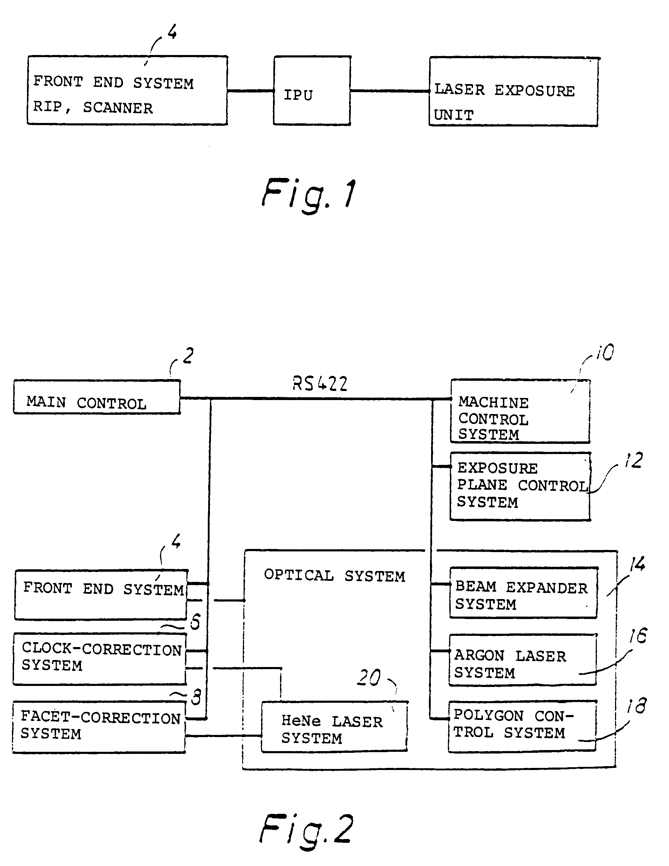

Figure 2 is a diagrammatic view of the laser exposure unit according to the invention. The laser exposure unit comprises a main control 2, a front end system 4, a clock-correction system 6 and a facet-correction system 8. The facet-correction system 8 communicates through a serial bus RS 422 with a machine control system 10, a control system 12 for the exposure plane, a beam expander control system 14, an argon laser system 16 and a polygon control system 18. The beam expander control system 14, the argon laser system 16 and the polygon control system 18 form part of an optical system also including an HeNe-laser system 20 controlling the clock-correction system 6 and the facet-correction system 8. The main control 2 performs the superior control of the entire system and controls all the submodules. In addition, the main control performs the external communication through the front end system 4. The clock-correction system 6 performs a correction so as to achieve an accuracy of the data flow to the printing plate to be exposed, a particular curving inside the machine necessitating a correction of the data in response to the position in the plane. The facet-correction system 8 corrects for errors in the reflecting facets of the polygonal mirror 32. The machine control system 10 performs the communication to current relays etc. The modules communicate with one another through a standard communication line RS 422 and software protocols.

The control system 12 controlling the exposure plane controls the movement of the exposing surface, i.e. the printing plate, by means of sensors.

The optical system is controlled by electronic circuits. The beam expander system 14 controls the spot size of the pixels, and the argon laser 16 produces the laser beam exposing the printing plate. The laser beam from the HeNe-laser 20 is used for a clock correction and a facet correction. The laser exposing unit cannot operate as desired without the latter correcting beam.

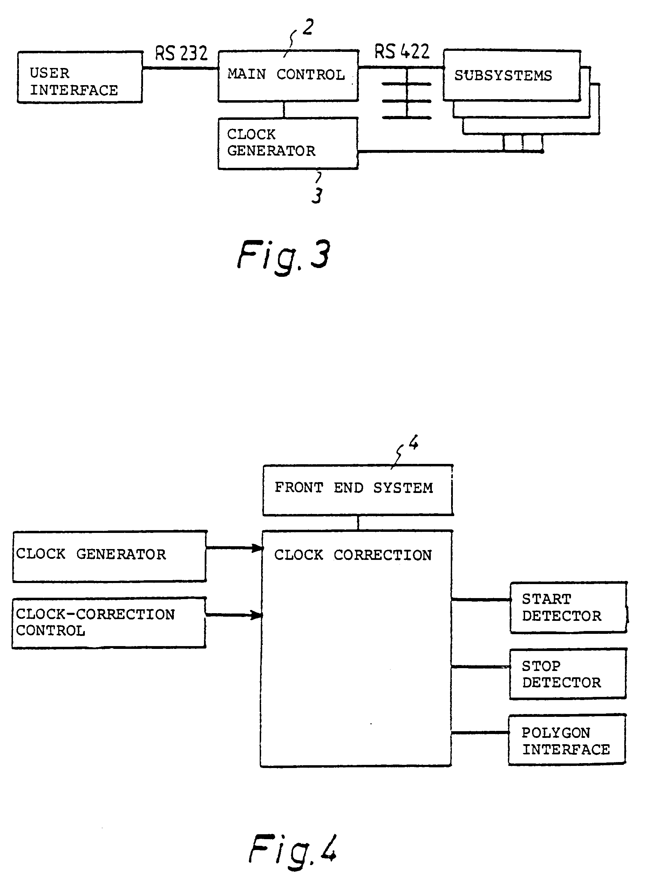

A user interface, cf. Figure 3, communicates through an RS 232 bus with the main control 2 communicating internally through said RS 422 bus. A clock control 3 provides the necessary synchronising.

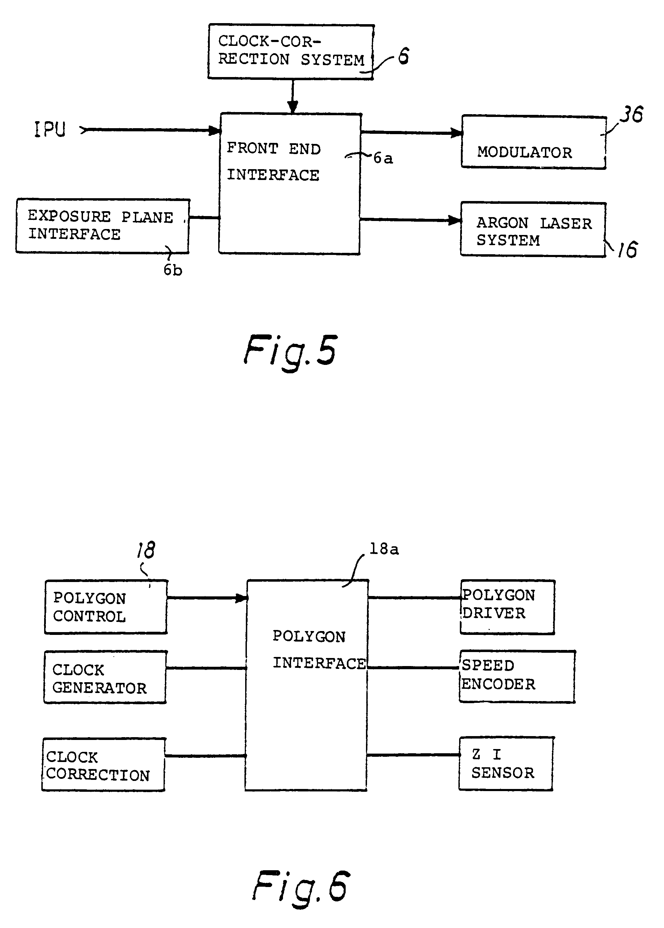

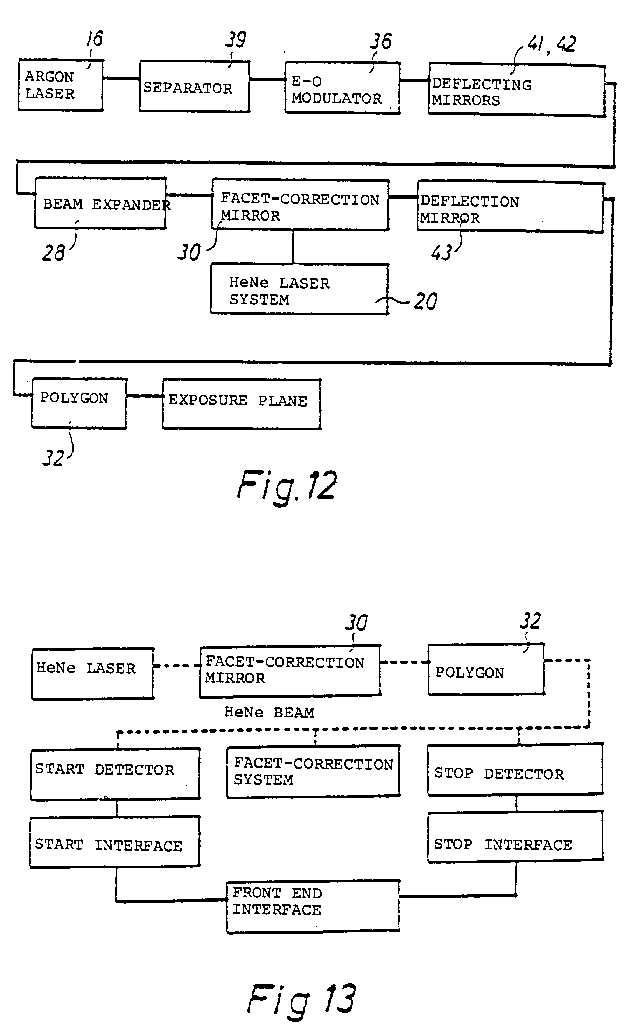

The data must be corrected in order to allow the system to operate as planned, and for this purpose a clock-correction module is provided, cf. Figure 4. The data between a starting and a stopping detector are corrected on the basis of the clock frequency from the clock generator and the correction data from the clock-correction control so as to obtain a uniform distance between the pixels in the plane. The clock-correction system 6 modifies the serial bit-flow generated by means of the front end system 4 for mechanical errors. The correction is the sum of correction for geometrical errors, for dividing errors and for polygon errors. The clock correction causes a generation of adjusted clock signals for the front end interface, cf. Figure 5. These signals are called DATA CLK. The front end interface 6a performs the external communication through a so-called IPU recoding data from other systems to a particular bit-flow suitable for exposure. The front end interface 6a receives the bit-flow together with correction values from the clock-correction system 6 and transmits said data to an electro-optical modulator 36, cf. Figure 12. The electro-optical modulator modulates the exposure beam in response to the data information.

In other words, the front end interface 6a presents a datalink between IPU and the laser exposure unit. The data are transferred together with handshake signals to the interface through a databus of a bus width corresponding to one word. The interface 6a adjusts the data to the correction data from the clock-correction system 6 and converts the corrected data into a serial bit-flow being transmitted to the modulator 36 for modulation of the exposure beam.

The front end interface 6a also generates an external modulation signal for the argon laser system 16 based on the received handshake signals and status of the control system 12 for the exposure plane. Access to the control system 12 for the exposure plane is achieved through the exposuring plane interface.

As shown in Figure 6, the polygon control system 18 controls the rotation of a rotating polygonal mirror 32 scanning lines on the offset plate. The polygon control system 18 communicates with the main control 2 through the serial bus RS 422. The main control 2 controls a driving motor 51 for the polygonal mirror 32 through a polygon interface 18a. A power-dump in connection with the driving motor for the polygon can absorb energy generated during a decelleration.

The polygon interface 18a receives the reference clock signal for the driving motor 51, i.e. a stepmotor, from the clock generator, said clock signal being scaled down to the lower frequency. The driving system operates in a closed loop configuration, where a polygon encoder generates information on speed to the interface.

A transducer detects the position of the polygon 32 and informs the clock-correction system so as to synchronize the correction with the position of the polygon.

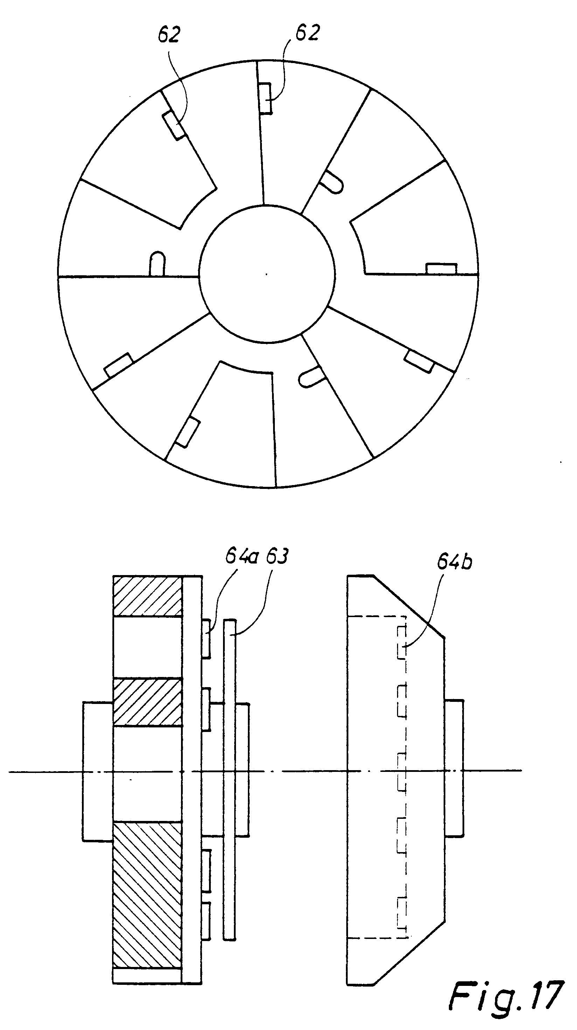

The stepmotor 51 is connected to a polygon/air bearing unit 53 through a hysteresis-dampened magnetic coupling, cf. Figure 17, ensuring a rotational accuracy of 6 ppm per rotation.

The control system 12 for the exposure plane controls the movement of the exposure plane, i.e. the printing plate, by means of detectors and an encoder. The encoder provides an indication of the position and is an electronic unit optionally mounted on a shaft. Such a unit transmits a predetermined number of pulses per rotation; in the present case 1250 pulses per rotation, i.e. a dissolution of 1250 pulses. The pulses are transmitted to a counter to achieve an absolute indication of the position, said indication of the position being used for controlling the movement of the exposure plane. The control of the exposure plane is in turn controlled by the clock frequency from the system clock determining the superior speed of the system.

The exposure plane rests on air bearings on a block of granite and is driven by a spindle system connected to an exposure plane motor and a DC motor.

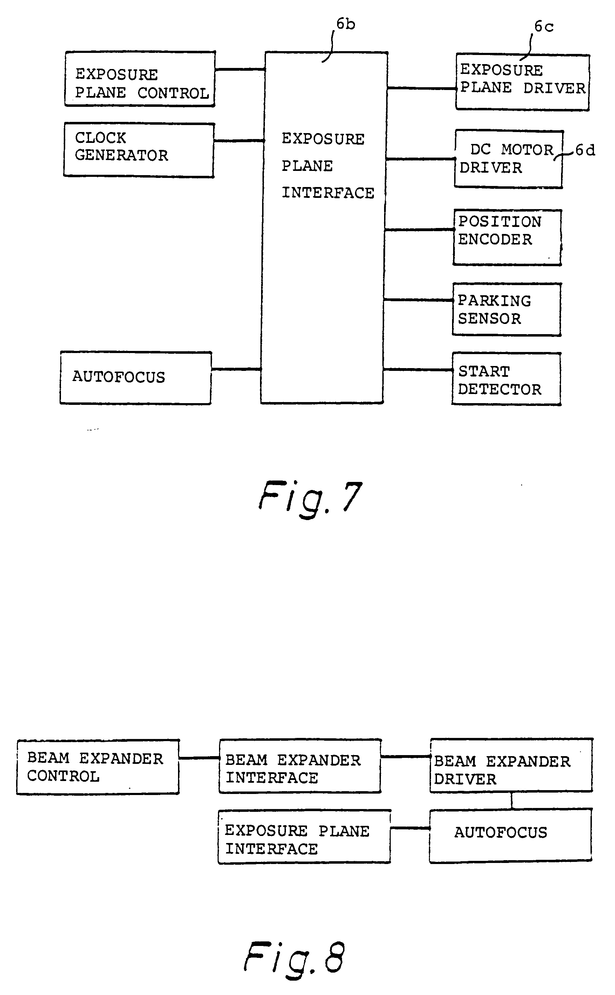

The interface 6b of the exposure plane interfaces the Z 80 exposure plane control and the clock generator with the exposure plane driving device 6c and the DC motor driving device, cf. Figure 7. In addition, the interface generates information on the position of the exposure plane to the exposure plane control. The interface receives the signal scaled down from the clock-pulse generator and generates the control and clock signal for the exposure plane driving device 6c and the DC motor driving device 6d in response to the input signal from the exposure plane control. The exposure plane interface 6b generates furthermore information on the position to the control on the basis of signals from the exposure plane encoder, autofocus, holding and starting position detectors. The exposure plane driving device 6c controls the exposure plane motor during the exposure in a closed loop configuration while using the encoder feedback coupling and f-exp input. While moving quickly the DC motor takes over the control and decouples the exposure plane motor through a magnetic coupling not shown. The DC motor controls furthermore some detectors detecting movement errors.

The beam expander control system 14 determines the spot size of the exposing beam. The spot size depends on the desired dissolution and the spot factor. The spot factor describes the overlapping during the scanning. The spot must overlap by a predetermined distance during a line scanning so as to achieve a uniform exposure of the plate. In connection with a 1000 line dissolution, the overlapping corresponds to a distance of 10 microns between the scanning lines on the plate. Then the spot must be of a size exceeding 10 microns in order to ensure an overlapping. A suitable value is between a factor 2 to a factor 3, i.e. for the line distance of 10 microns the spot size corresponds to between 20 to 30 microns, which provides a uniform exposure as the resulting spots have a suitable overlapping.

The beam expander 14 is an eight-position Galilean unit with a fixed focal plane. The expander comprises a revolving head 28 with eight different magnifying lenses.

The argon laser 16 represents the actual light source for the exposure and communicates with a laser control through a serial bus. The laser control ensures that the argon laser 16 is driven by the desired power.

The machine control system 10 forms the interface between the microprocessor and the heavy power signals. A vacuum pump retaining the printing plate to be exposed is for instance controlled by a machine interface converting 5 V signals into high-voltage signals for controlling purposes.

The control system includes an HeNe-laser system 20 in connection with feedback loops.

The feedback loops correct both facet errors and operation because the facet-correction detector 61 is displaced in response to the slow changes, i.e. follows the slow changes due to for instance thermal operation. The correction of slow changes is performed between two succeeding scannings so as not to interfere with the scanning. Facet errors are furthermore corrected.

The facet-correction system 8 serves to correct errors and inaccuracies of the polygon facets. For this purpose, a facet-correction detector 61 is provided which generates a feedback signal. The feedback signal controls some piezoelectric transducers 30a capable of changing the position of a facet-correction mirror 30 in the beam path in response to the error possibly appearing at any time. In this manner possible errors on the facets 32 of the polygon are eliminated, the line distance thereby being the same across the entire printing plate and for each facet.

The laser beam from the argon laser 16 is transmitted through a separator 39 performing a choice of wavelength for the sake of the succeeding electrooptical modulator 36. The modulator 36 turns the laser beam on and off in response to the data-flow from the front end system 4. The modulated laser beam is deflected by means of two mirrors 41, 42 deflecting the beam and transmitting it through the beam expander 28. In the beam expander 28, the laser beam is focused so as to achieve a suitable spot size on the printing plate to be exposed. The expanded output signal is mixed with the laser beam from the HeNe-laser 20 and reflected and redirected by means by the facet-correction mirror 30 in response to the output signal of the facet-correction system 8. The two beams are transmitted by means of the deflection mirror 43 to the active facet of the rotating polygon 32.

The reflected exposuring beam sweeps the exposing surface while the reflected HeNe-laser beam is detected by means of start/stop detectors and the facet-correction detector 61 before it is blocked so as to avoid an incorrect exposure.

Finally, the HeNe-laser system 20 is illustrated, said system transmitting a correcting beam almost parallel to the argon laser beam from the facet-correction mirror 30. The correcting beam is adapted to find the starting and stopping position of the plane and serves to correct errors in the facets of the polygon.

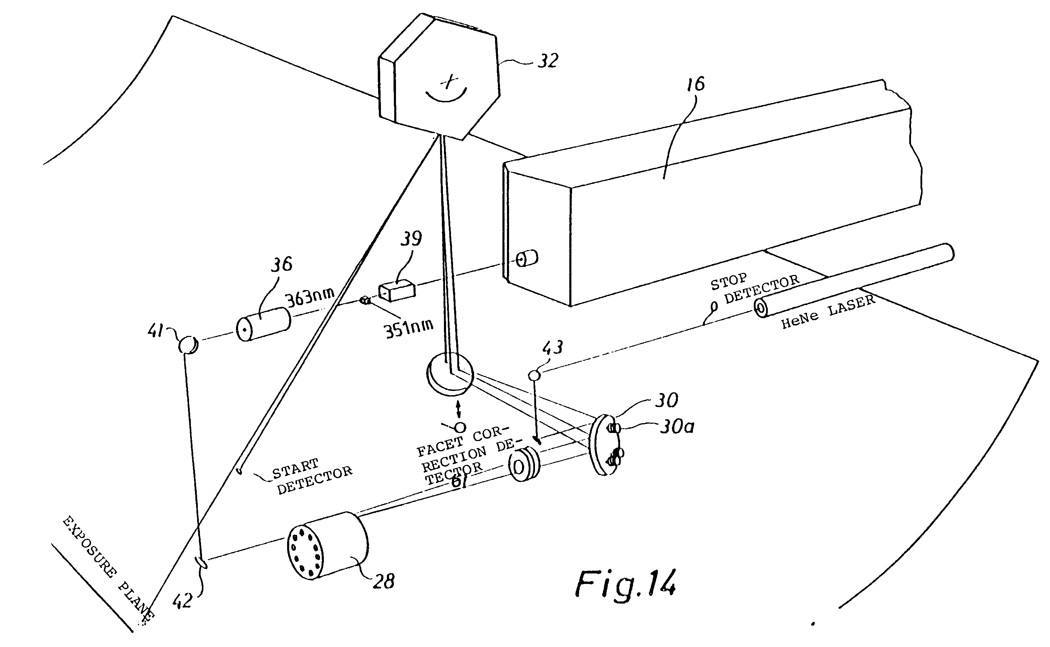

Figure 14 illustrates the entire optical system and the argon laser 16 transmitting a laser beam to the separator 39. The separator 39 comprises two members, viz. a quartz block and a polarisator. The quartz block exhibits the ability that it differently turns the polarization of dissimilar wavelengths, i.e. when two light beams of wavelengths with the same polarization direction are transmitted, said light beams exit the crystal in dissimilar polarization directions. The latter ability of the quartz block is utilized for providing a quartz crystal of exactly the length ensuring that the polarization directions of the emitted wavelengths are turned 90° relative to one another. Subsequently, the laser beams transmitted in dissimilar polarization directions are separated by means of a polarisator 34 in form of a glass crystal with a dieelectric film of an angle of 45° relative to the direction of radiation. In this manner the two beams are separated into a straight beam and a beam deflected aside. The straight beam is utilized and transmitted through a modulator 36 controlled by an electric signal so as to turn the beam on and off. Some mirrors deflect the beam and transmit said beam through the beam expander in form of a revolving head 28 with eight different lenses allowing the choice of the desired spot size. The revolving head 28 is turned in response to the desired spot size. The output signal of the beam expander 28 is transmitted to the facet-correction mirror 30 correcting possible polygonal errors. The reflecting mirror deflects the beam towards the polygon surface scanning the beam on the plane while rotating. The HeNe-laser 20 emits a laser beam hitting the facet-correction mirror 30 and the deflection mirror, and after a number of deflections the laser beam hits the polygon 32 and is emitted in a slightly different direction than the argon laser in such a manner that it can be detected by some starting and stopping detectors without interrupting the ultraviolet beam. In addition, the laser beam is received by the facet-correction detector 61 disposed in the middle.

Figure 17 illustrates the magnetic coupling comprlsing intermeshing, radially projecting members, which can be slightly rotated relative to one another. Strong magnets 62 are built in the opposing surfaces of these radially projecting members in such a manner that they repel one another during the transfer of a rotational movement. A hysteresis-dampened magnetic coupling is furthermore provided in connection with the magnetic coupling, said hysteresis-dampened magnetic coupling comprising a relatively thick copper plate 63 non-rotationally connected to one set of radially projecting members. A set of strong magnets 64a, 64b are provided on both sides of the copper plate 63, said magnets attracting one another. When the copper disk 63 is moved relative to the magnets 64a, 64b, a hysteresis current is generated in said copper disk 63 and has a strongly dampening effect on said relative movement.

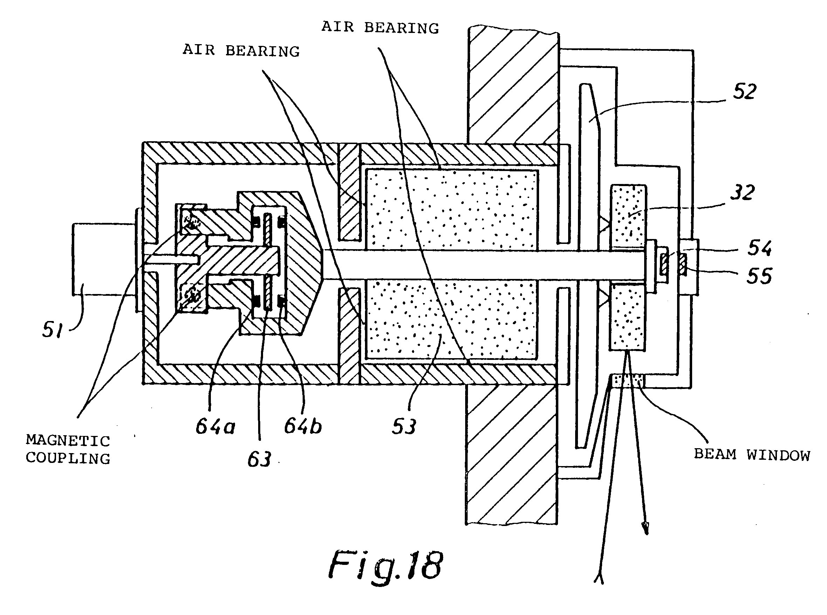

Figure 18 illustrates the rotational shaft with the hysteresis-dampened magnetic coupling, the air bearing and the flywheel 52, the polygon being secured to said flywheel. The portion of the rotational shaft disposed in the air bearing comprises a cylinder 53 of a relatively heavy material, such as granite. The flywheel 52 is placed to the right of the granite cylinder 53, the polygonal mirror 32 being secured to said flywheel in an adjustable manner. A relatively strong magnet 54 is placed at the end of the shaft, said magnet 54 being repelled in axial direction by a second fixed magnet 55. The axial position of the rotational shaft is maintained by means of the pressure inside the air bearing and in particular by the pressure causing a pressing of the shaft in axial direction against the force of the magnets 54, 55. The shaft is caused to rotate by a stepmotor 51 disposed to the left of the magnetic coupling.

The combination of the faraday-dampened magnetic coupling, the air bearing and the inertia of the granite cylinder 53, the flywheel 52 and the polygon 32, respectively, ensures the extremely high rotational accuracy of 6 ppm per rotation at the rotational speeds in question.

## Claims

1. A scanning device for producing printing plates comprising a laser for generating a laser beam, a polygonal mirror (32) having the laser beam directed thereon, means for supporting the polygonal mirror for rotational movement on a rotational shaft a magnetic coupling for transmitting a rotational movement to the polygonal mirror via the shaft such that the rotating polygonal mirror causes a scanning of the laser beam, and means (63, 64a, 64b) for dampening possible oscillations of the rotating polygonal mirror and rotational shaft by hysterisis, faraday-dampening, whereby as rotational movement is transferred to the polygonal mirror by means of the magnetic coupling, possible oscillations are dampened by hysteresis, faraday dampening.

2. A scanning device as claimed in claim 1, wherein said magnetic coupling includes intermeshing, radially projecting members comprising strong magnets (62) which can be slightly rotated relative to one another.

3. A scanning device as claimed in claim 2, wherein the strong magnets (62) are disposed such that they repel one another.

## Patentansprüche

1. Abtastvorrichtung zum Herstellen von Druckplatten, die einen Laser zum Erzeugen eines Laserstrahls, einen Polygonalspiegel (32), auf den der Laserstrahl gerichtet ist, Mittel zum Tragen des Polygonalspiegels zwecks Drehbewegung auf einer Drehwelle, ein magnetisches Koppelelement zum Übertragen einer Drehbewegung auf den Polygonalspiegel über die Welle, so daß die Drehung des Polygonalspiegels ein Abtasten des Laserstrahls hervorruft, und Mittel (63, 64a, 64b) zum Dämpfen möglicher Oszillationen des sich drehenden Polygonalspiegels und der Drehwelle durch Hysterese, Faraday-Dämpfung, umfaßt, wobei mögliche Oszillationen durch Hysterese, Faraday-Dämpfung, gedämpft werden, wenn auf den Polygonalspiegel mittels des magnetischen Koppelelements Drehbewegung übertragen wird.

2. Abtastvorrichtung nach Anspruch 1, dadurch gekennzeichnet, daß besagtes magnetisches Koppelelement ineinandergreifende, sich nach außen erstreckende Glieder enthält, die starke Magneten (62) umfassen, die ein wenig relativ zueinander gedreht werden können.

3. Abtastvorrichtung nach Anspruch 2, dadurch gekennzeichnet, daß die starken Magnete (62) so angeordnet sind, daß sie sich gegenseitig abstoßen.

## Revendications

1. Dispositif de balayage pour fabriquer des clichés, comprenant un laser pour engendrer un faisceau laser, un miroir polygonal (32) sur lequel est dirigé le faisceau laser, un moyen pour supporter le miroir polygonal en vue d'un mouvement de rotation sur un arbre rotatif, un accouplement magnétique pour transmettre un mouvement de rotation au miroir polygonal par l'intermédiaire de l'arbre de telle sorte que le miroir polygonal rotatif provoque une balayage du faisceau laser, et des moyens (63, 64a, 64b) pour amortir les oscillations éventuelles du miroir polygonal rotatif et de l'arbre rotatif par amortissement Faraday et hystérésis, grâce à quoi le mouvement de rotation est transféré au miroir polygonal au moyen de l'accouplement magnétique et, les oscillations éventuelles sont amorties par amortissement Faraday et hystérésis.

2. Dispositif de balayage selon la revendication 1, dans lequel ledit accouplement magnétique comprend des éléments saillant qui font saillie radialement et qui sont en prise mutuelle et comprennent des aimants puissant (62) qui peuvent tourner légèrement les uns par rapport aux autres;

3. Dispositif de balayage selon la revendication 2, dans lequel les aimants puissants (62) sont disposés de telle sorte qu'ils se repoussent les uns les autres.
